(19) Europäisches Patentamt | European Patent Office | Office européen des brevets

(11) **EP 4 776 826 A1**

(12) **EUROPEAN PATENT APPLICATION**
published in accordance with Art. 153(4) EPC

(43) Date of publication:
**15.07.2026  Bulletin 2026/29**

(21) Application number: **24863105.3**

(22) Date of filing: **27.08.2024**

(51) International Patent Classification (IPC):
*H10N 97/00* (2023.01)    *H01L 21/033* (2006.01)

(52) Cooperative Patent Classification (CPC):
**H10N 97/00; H10P 76/40**

(86) International application number:
**PCT/KR2024/012790**

(87) International publication number:
**WO 2025/053524 (13.03.2025 Gazette 2025/11)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **07.09.2023  KR 20230119024**

(71) Applicant: **LG Innotek Co., Ltd.
Seoul 07796 (KR)**

(72) Inventors:
• **PARK, Jin Gyeong
Seoul 07796 (KR)**
• **KIM, Tae Hoon
Seoul 07796 (KR)**
• **KIM, Kab Young
Seoul 07796 (KR)**

(74) Representative: **DREISS Patentanwälte PartG
mbB
Friedrichstraße 6
70174 Stuttgart (DE)**

(54)    **CAPACITOR**

(57)    A capacitor according to one embodiment of the present invention comprises: a base which includes a first surface and a second surface opposite to the first surface and which includes a plurality of structures protruding from the second surface in a first direction from the first surface toward the second surface; a first electrode layer disposed on the structure and the second surface between the plurality of structures; a first dielectric layer disposed on the first electrode layer; and a second electrode layer disposed on the first dielectric layer, wherein the second surface between the plurality of structures is more porous than the structure.

FIG. 1

**Description**

[Technical Field]

An embodiment of the present invention relates to a capacitor.

[Background Art]

Semiconductor packages are applied to various fields such as vehicles, communications, and computers, and generally include a printed circuit board, a semiconductor chip disposed on the printed circuit board, and a passive element disposed on the printed circuit board. The passive element may include, for example, a resistor, an inductor, a capacitor, etc.

As semiconductor packages become more advanced, demands for capacitors having high performance, high reliability, and ultra-small size are increasing. In order to satisfy such demands, silicon-based capacitors and anodic aluminum oxide (AAO)-based capacitors have been proposed. The silicon-based capacitor includes an electrode layer, a dielectric layer, and an electrode layer that are sequentially stacked on a silicon base, and the AAO-based capacitor includes an electrode layer, a dielectric layer, and an electrode layer that are sequentially stacked on an AAO base.

As the need for reducing a signal path of the semiconductor packages and reducing a size of the semiconductor packages increases, a high-capacitance capacitor that can be mounted inside or underneath the semiconductor package is required.

[Disclosure]

[Technical Problem]

A technical object to be achieved by the present invention is to provide an ultra-small and high-capacitance capacitor.

[Technical Solution]

A capacitor according to an embodiment of the present invention includes: a base including a first surface and a second surface opposite to the first surface, and including a plurality of structures protruding from the second surface in a first direction from the first surface toward the second surface; a first electrode layer disposed on the second surface between the plurality of structures and the structure; a first dielectric layer disposed on the first electrode layer; and a second electrode layer disposed on the first dielectric layer, wherein the second surface between the plurality of structures is more porous than the structure.

The capacitor may further include a first metal layer disposed between the second surface between the plurality of structures and the first electrode layer, wherein the first metal layer may include at least one of titanium (Ti) or tungsten (W), and the first metal layer may be in direct contact with the first electrode layer.

The capacitor may further include a second metal layer disposed between the second surface between the plurality of structures and the first metal layer, wherein the second metal layer may include at least one of gold (Au) or silver (Ag).

The second surface between the plurality of structures may be in direct contact with the first electrode layer.

An average width of the plurality of structures in a second direction perpendicular to the first direction in which the plurality of structures protrude may be 1.5 $\mu$m to 3.5 $\mu$m, and an average height of the plurality of structures based on the second surface of the base may be 3.5 $\mu$m or greater and 175 $\mu$m or less.

The average width of the plurality of structures in the second direction may be 2 $\mu$m to 3 $\mu$m, and the average height of the plurality of structures based on the second surface of the base may be 30 $\mu$m or greater and 120 $\mu$m or less.

A ratio of an average height of the plurality of structures based on the second surface of the base to an average width of the plurality of structures in the second direction perpendicular to the first direction in which the plurality of structures protrude may be 1 to 50.

The ratio of the average height of the plurality of structures to the average width of the plurality of structures may be 15 to 40.

An angle formed between the second surface of the base and a side surface of the structure may be 90 degrees to 100 degrees.

The first electrode layer may include at least one of titanium (Ti), molybdenum (Mo), tungsten (W), indium-tin, or copper (Cu), and the second electrode layer may include aluminum (Al).

A capacitor according to another embodiment of the present invention may include: a base including a first surface and a second surface opposite to the first surface, and including a structure protruding from the second surface in a direction from the first surface toward the second surface; a first metal layer disposed on the second surface and including a first through-hole; a second metal layer disposed on the first metal layer and including a second through-hole; a first electrode layer disposed on the second metal layer and the structure; a first dielectric layer disposed on the first electrode layer; and a second electrode layer disposed on the first dielectric layer, wherein the structure penetrates the first through-hole and the second through-hole, an etching rate of the first metal layer is higher than an etching rate of the second metal layer, and a silicon diffusion coefficient of the second metal layer is lower than a silicon diffusion coefficient of the first metal layer.

The first metal layer may include at least one of gold (Au) or silver (Ag), and the second metal layer may include at least one of titanium (Ti) or tungsten (W).

[Advantageous Effects]

According to an embodiment of the present invention, an ultra-small high-capacitance capacitor can be provided. In addition, according to an embodiment of the present invention, a capacitor having a simple manufacturing process, low cost, and high reliability can be provided.

[Description of Drawings]

FIG. 1 is a cross-sectional view of a capacitor according to an embodiment of the present invention.
FIG. 2 is a cross-sectional view of a capacitor according to another embodiment of the present invention.
FIG. 3 is a cross-sectional view of a capacitor according to still another embodiment of the present invention.
FIG. 4 is a cross-sectional view of a capacitor according to still another embodiment of the present invention.
FIG. 5 is a cross-sectional view of a capacitor according to still another embodiment of the present invention.
FIG. 6 is a cross-sectional view of a capacitor according to still another embodiment of the present invention.
FIGS. 7 to 9 illustrate a method of manufacturing a capacitor according to an embodiment of the present invention.
FIG. 10 is a diagram for describing an etching mechanism in a manufacturing process of a plurality of structures in the capacitor according to an embodiment of the present invention.
FIG. 11 is SEM images of structures manufactured according to an embodiment of the present invention.
FIGS. 12 to 13 are cross-sectional views of a capacitor according to yet another embodiment of the present invention.

[Modes of the Invention]

Hereinafter, exemplary embodiments of the present invention will be described in detail with reference to the accompanying drawings.
However, the spirit of the present invention is not limited to the embodiments described below, and the present invention may be embodied in various forms. One or more components of the embodiments may be selectively combined or substituted with one another within the spirit or scope of the present invention.
In addition, the terminology used in the embodiments of the present invention, including technical and scientific terms, unless explicitly defined otherwise, shall be interpreted as having meanings that are generally understood by those of ordinary skill in the art to which the present invention pertains, and terms having meanings commonly understood, such as those defined in dictionaries, shall be interpreted in the context of the related technologies.
In addition, the terminology used in the embodiments of the present invention is used for the purpose of describing the embodiments only and is not intended to limit the scope of the present invention.
In the present specification, the singular forms can be understood to include plural forms unless otherwise indicated, and the expression "at least one of A, B, and/or C" can be understood to include any combination of one or more A, B, and C.
In addition, expressions such as "first," "second," "A," "B," "(a)," and "(b)," may be used to describe components of embodiments of the present invention.
These expressions are used solely to distinguish one component from another, and do not limit the substance, order, or arrangement of the corresponding components.
Furthermore, when an component is described as being "connected," "combined," or "accessed" to another component, the description should be understood to include that the component is "connected," "combined," or "accessed" to the other component not only directly, but also indirectly through one or more intervening components.
In expression "formed or disposed "on (over) or under (below)" another component," the terms "on (over)" and "under (below)" include not only a direct contact between two components, but also formation or disposition in which one or more other components are interposed between the two components. Furthermore, the terms "on (over)" and "under (below)" may refer to both upper and lower directions relative to one component.

Hereinafter, embodiments of the present invention will be described in detail with reference to the accompanying drawings. The same reference numerals refer to the same or corresponding components throughout the drawings, and redundant descriptions thereof will be omitted.

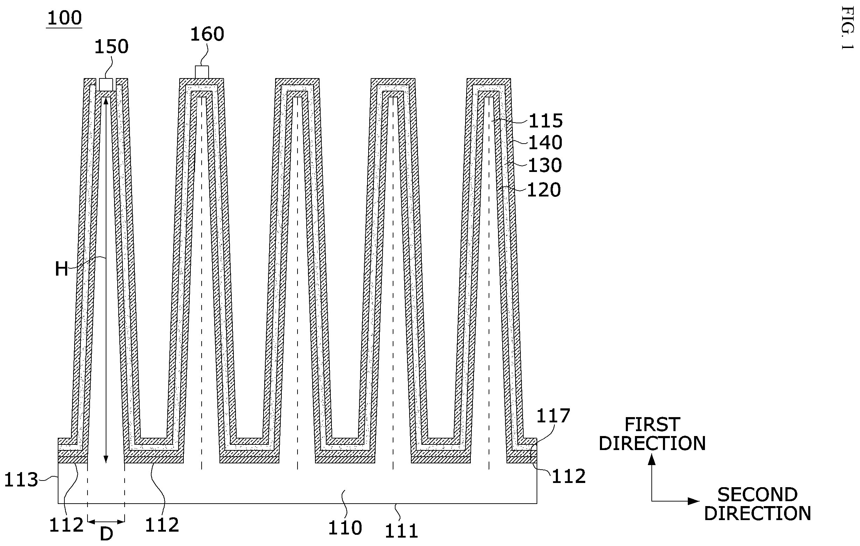

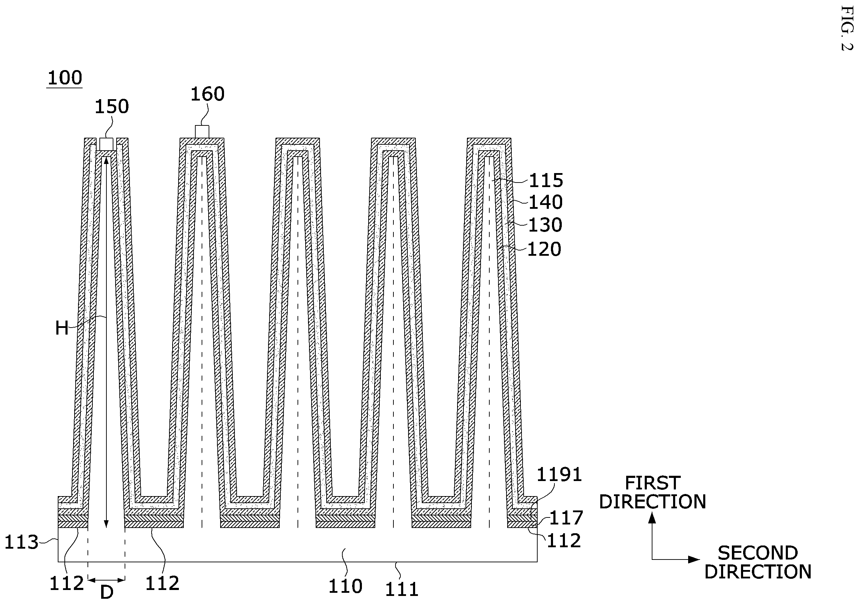

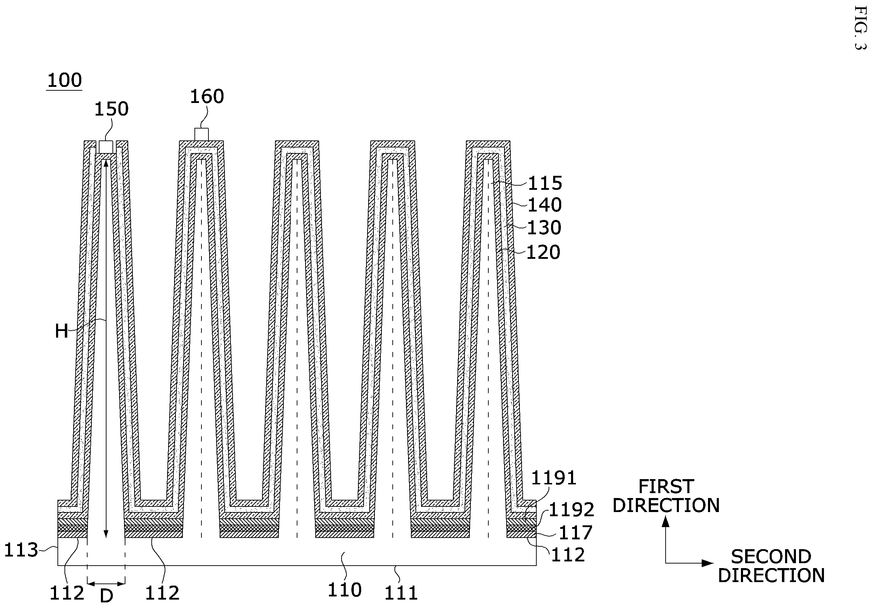

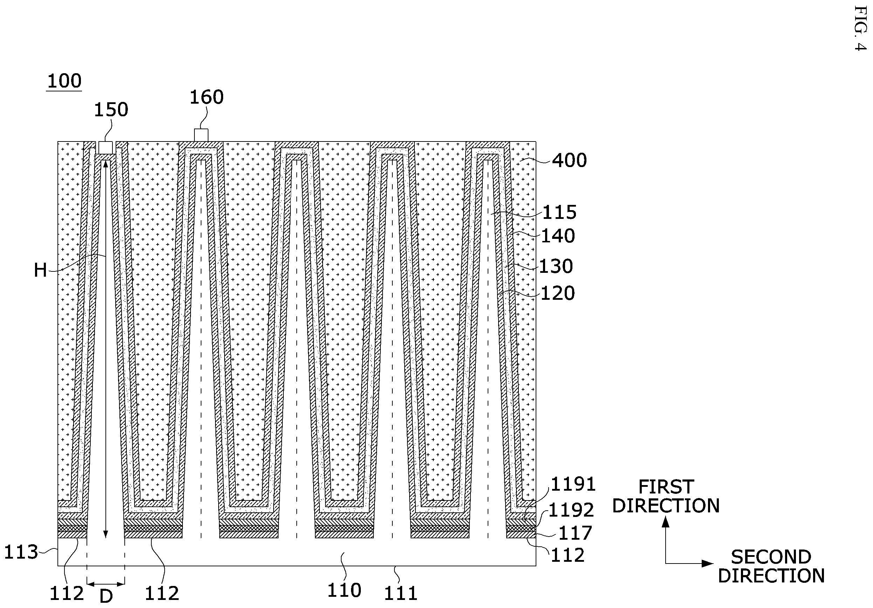

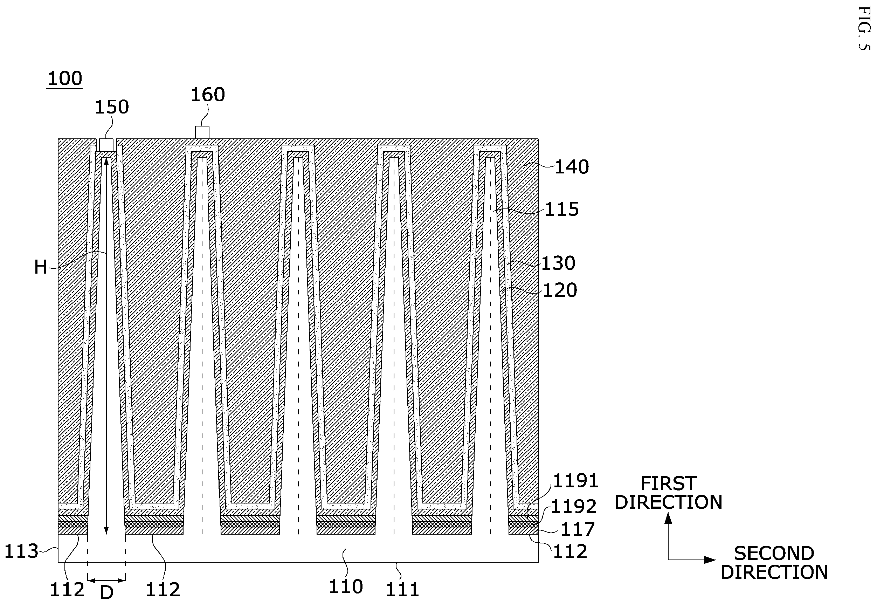

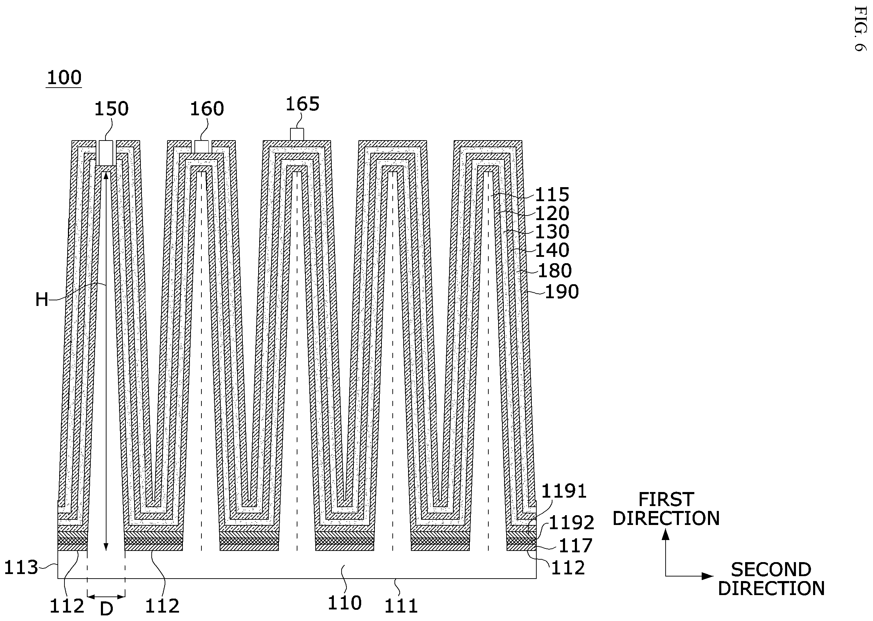

FIG. 1 is a cross-sectional view of a capacitor according to an embodiment of the present invention, FIG. 2 is a cross-sectional view of a capacitor according to another embodiment of the present invention, FIG. 3 is a cross-sectional view of a capacitor according to still another embodiment of the present invention, FIG. 4 is a cross-sectional view of a capacitor according to still another embodiment of the present invention, FIG. 5 is a cross-sectional view of a capacitor according to still another embodiment of the present invention, and FIG. 6 is a cross-sectional view of a capacitor according to still another embodiment of the present invention.

Referring to FIGS. 1 to 3, a capacitor 100 includes a base 110, a first electrode layer 120, a first dielectric layer 130, and a second electrode layer 140.

The base 110 includes a first surface 111, a second surface 112 opposite to the first surface 111, and a third surface 113 disposed between the first surface 111 and the second surface 112. The first surface 111, the second surface 112, and the third surface 113 may be referred to as an upper surface, a lower surface, and a side surface, respectively.

The base 110 may include a semiconductor material or a non-conductor material. For example, the base 110 may be a silicon (Si) substrate. For example, the base 110 may be a doped silicon substrate. For example, the base 110 may be an n-type doped silicon substrate or a p-type doped silicon substrate.

According to an embodiment of the present invention, the base 110 includes a structure 115 protruding from the second surface 112 in a first direction from the first surface 111 toward the second surface 112. The base 110 includes a plurality of structures 115, and the plurality of structures 115 are disposed to be spaced apart from each other. In this case, the plurality of structures 115 may include silicon and may be integrated with the base 110. That is, the plurality of structures 115 may extend from the second surface 112 of the base 110. The plurality of structures 115 may be formed by a method of etching a silicon substrate. To form the plurality of structures 115, the silicon substrate may be etched in a concave shape or etched in a convex shape. The plurality of structures 115 may have an identical shape or a regular shape, and a separation distance between the plurality of structures 115 may have a pattern that is the same as each other, regularly increases, or regularly decreases.

According to an embodiment of the present invention, at least a portion of the plurality of structures 115 may have a pyramid shape. For example, at least a portion of the plurality of structures 115 may have a polygonal pyramid shape or a cone shape. For example, at least a portion of the plurality of structures 115 may have a triangular pyramid shape. Alternatively, at least a portion of the plurality of structures 115 may have a column shape. For example, at least a portion of the plurality of structures 115 may have a polygonal column shape or a cylindrical shape. For example, at least a portion of the plurality of structures 115 may have a triangular prism shape. In the present specification, when a ratio of an area of a top surface to an area of a bottom surface of each structure 115 is 1 time or less, it may be referred to as a pyramid shape. That is, when an angle $\theta$ formed between a bottom surface and a side surface of each structure 115 is less than 90 degrees, it may be referred to as a pyramid shape. In the present specification, when the ratio of the area of the top surface to the area of the bottom surface of each structure 115 is 1 time, it may be referred to as a column shape. That is, when the angle $\theta$ formed between the bottom surface and the side surface of each structure 115 is 90 degrees, it may be referred to as a column shape. Here, a bottom surface of each structure 115 is a surface extending in a horizontal direction from a second surface 112 between the plurality of structures 115 toward each structure 115, and a top surface of each structure 115 may be a surface opposite to the bottom surface of the corresponding structure 115 in a first direction.

In this case, an angle $\theta$ formed between the bottom surface and the side surface of each structure 115 may be 80 degrees to 90 degrees, preferably 85 degrees to 90 degrees. That is, an angle $(180-\theta)$ formed between the side surface of each structure 115 and the second surface 112 of the base 110 in a separation region between the plurality of structures 115, that is, the second surface 112 between the plurality of structures 115, may be 90 degrees to 100 degrees, preferably 90 degrees to 95 degrees. When the angle $\theta$ exceeds 90 degrees, fabrication of the plurality of structures 115 may be difficult, and when the angle $\theta$ is less than 80 degrees, it may be difficult to have a sufficient specific surface area for implementing a capacitor. When the angle $\theta$ formed between the bottom surface and the side surface of each structure 115 satisfies this numerical range, the number of structures 115 disposed per unit area may be maximized, and the surface area of the structures 115 per unit volume may also be maximized.

In this case, at least some of the plurality of structures 115 may be parallel to each other. For example, an imaginary extension line from a center of a bottom surface to a center of a top surface of one of the plurality of structures 115 may be parallel to an imaginary extension line from a center of a bottom surface to a center of a top surface of another one of the plurality of structures 115. Accordingly, since the first electrode layer 120 may be deposited with a uniform thickness on surfaces of the plurality of structures 115, a capacitor having high reliability may be obtained.

According to an embodiment of the present invention, an average width D of the bottom surfaces of the plurality of structures 115 in a second direction perpendicular to the first direction may be 1.5 $\mu$m to 3.5 $\mu$m, preferably 2 $\mu$m to 3 $\mu$m.

According to the embodiment, it is possible to minimize the possibility of damage to the structure and increase durability while having a sufficient specific surface area for implementing a capacitor.

In this case, an average height H of the plurality of structures 115 based on the second surface 112 of the base 110 may be 3.5 μm or greater and 175 μm or less, preferably 30 μm or greater and 120 μm or less, and more preferably 40 μm or greater and 60 μm or less. In this case, the height H of each structure 115 may be a height from the second surface 112 of the base 110. According to the embodiment, fabrication of the structure may be easy while having a sufficient specific surface area for implementing a capacitor.

According to the embodiment, a ratio H/D of the average height H of the plurality of structures 115 based on the second surface 112 of the base 110 to the average width D of the plurality of structures 115 in the second direction perpendicular to the first direction in which the plurality of structures 115 protrude may be 1 to 50, preferably 15 to 40, and more preferably 20 to 30. According to the embodiment, while having a sufficient specific surface area for implementing a capacitor, fabrication of the structure may be easy.

According to an embodiment of the present invention, the first electrode layer 120 is disposed on the base 110; the first dielectric layer 130 is disposed on the first electrode layer 120; the second electrode layer 140 is disposed on the first dielectric layer 130; the first electrode pad 150 is connected to the first electrode layer 120; and a second electrode pad 160 is connected to the second electrode layer 140.

The capacitance of the capacitor may be calculated according to Equation 1 below.

【Equation 1】

$$C = \varepsilon \frac{S}{d}$$

In Equation 1, C is capacitance, ε is permittivity, S is an area of an electrode layer, and d is a distance between electrode layers. According to the embodiment, the capacitance may increase as the area of the electrode layer increases.

According to an embodiment of the present invention, a porous layer 117 is disposed so to be in contact with the second surface 112 of the base 110 in a separation region between the plurality of structures 115. That is, at least a portion of a surface of the second surface 112 of the base 110 in the separation region between the plurality of structures 115 may be porous. That is, the second surface 112 of the base 110 may be more porous than the structure 115. Alternatively, the second surface 112 of the base 110 may be more porous than the first surface 111 of the base 110. As used herein, porosity refers to a form having a plurality of small pores. The description that the second surface 112 of the base 110 may be more porous than the structure 115 may mean that the porosity of the second surface 112 of the base 110 is greater than the porosity of the structure 115. Similarly, the description that the second surface 112 of the base 110 is more porous than the first surface 111 of the base 110 may mean that the porosity of the second surface 112 of the base 110 is greater than the porosity of the first surface 111 of the base 110.

According to an embodiment of the present invention, the porous layer 117 may have the same material as the base 110 but be porous. For example, the porous layer 117 may be a porous silicon layer. That is, the porous layer 117 may be a silicon layer having a plurality of fine pores. According to the embodiment, a specific surface area of the second surface 112 of the base 110 in the separation region between the plurality of structures 115 may increase.

Referring to FIG. 1, the second surface 112 of the base 110 between the plurality of structures 115 is in direct contact with the first electrode layer 120. In this case, when the second surface 112 of the base 110 between the plurality of structures 115 is porous, bonding force between the porous layer 117 and the first electrode layer 120 increases, and the first electrode layer 120 may be uniformly disposed even in a boundary region between the second surface 112 of the base 110 and a side surface of the structure 115.

Referring to FIGS. 2 and 3, a first metal layer 1191 is disposed on the porous layer 117 in the separation region between the plurality of structures 115. When the first metal layer 1191 is disposed on the porous layer 117, the bonding force between the porous layer 117 and the first electrode layer 120 further increases through the first metal layer 1191, and an upper surface of the first metal layer 1191 may be planarized.

According to an embodiment of the present invention, the first metal layer 1191 is disposed on the second surface 112 of the base 110 and includes a through-hole, and the structure 115 is located inside the through-hole of the first metal layer 1191. According to an embodiment of the present invention, the structure 115 and the through-hole of the first metal layer 1191 are each plural, and each structure 115 may be disposed in each through-hole.

According to an embodiment of the present invention, the first electrode layer 120 is disposed on the first metal layer 1191 and the structure 115. Accordingly, the first metal layer 1191 may be in contact with the second surface 112 of the base 110, the side surface of the structure 115, and a lower surface of the first electrode layer 120. In this case, the first metal layer 119 and the first electrode layer 120 may be made of the same material or a different material.

Referring to FIG. 2, the first metal layer 1191 may include at least one of titanium (Ti) or tungsten (W). For example, the first metal layer 1191 may include at least one of titanium (Ti), titanium nitride (TiN), tungsten (W), or titanium tungsten (TiW).

Compared to a case in which the first electrode layer 120 is directly deposited on the second surface 112 of the base 110 made of silicon, when the first electrode layer 120 is deposited on the first metal layer 1191, the thickness of the first electrode layer 120 may be uniformly deposited, and the bonding force of the first electrode layer 120 may be improved. In particular, when the upper surface of the first metal layer 1191 is planarized by the porous layer 117, deposition of the first electrode layer 120 becomes easier.

Alternatively, referring to FIG. 3, a second metal layer 1192 may be further disposed between the second surface 112 of the base 110 and the first metal layer 1191. In this case, the second metal layer 1192 may include a metal having a higher etching rate and a lower silicon diffusion coefficient than the first metal layer 1191. For example, when the first metal layer 1191 includes at least one of titanium (Ti) or tungsten (W), the second metal layer 1192 may include at least one of gold (Au) or silver (Ag). Accordingly, the second metal layer 1192 may form the plurality of structures 115 by etching the base 110 at a high speed, and the first metal layer 1191 may prevent the diffusion of the second metal layer 1192, thereby reducing an impact of diffused gold (Au) or silver (Ag) on capacitance. To achieve this, the first metal layer 1191 may be disposed so as to cover the entire upper surface of the second metal layer 1192. That is, the second metal layer 1192 may be disposed so as not to be in direct contact with the first electrode layer 120.

According to an embodiment of the present invention, the first electrode layer 120 is disposed on the plurality of structures 115 and the metal layer.

In this case, the first electrode layer 120 may include at least one of titanium (Ti), molybdenum (Mo), tungsten (W), or indium-tin. For example, the first electrode layer 120 may include at least one of TiN, $TiO_2$, $MoO_x$, $WO_x$, ITO, or ITGO, where x is a positive integer.

Next, the first dielectric layer 130 is disposed on the first electrode layer 120 on the second surface 112 of the base 110 and the plurality of structures 115.

In this case, the first dielectric layer 130 may include at least one of $SiO_2$, $Si_3N_3$, $SiN_4$, ZAZ, $HfO_2$, $ZrO_2$, $Hf_xZr_yO_z$, or $Al_2O_3$, where x, y, and z are positive integers. When the material of the first dielectric layer 130 satisfies these conditions, it is easy to deposit the first dielectric layer 130 in a uniform thickness on the first electrode layer 120.

Next, the second electrode layer 140 is disposed on the first dielectric layer 130 on the second surface 112 of the base 110 and the plurality of structures 115.

In this case, the second electrode layer 140 may include at least one of titanium (Ti), molybdenum (Mo), tungsten (W), indium-tin, copper (Cu), or aluminum (Al). For example, the second electrode layer 140 may include at least one of TiN, $TiO_2$, $MoO_x$, $WO_x$, ITO, ITGO, Cu, or Al, where x is a positive integer.

The material of the second electrode layer 140 may be the same as the material of the first electrode layer 120, but is not limited thereto. That is, the material of the second electrode layer 140 may be different from the material of the first electrode layer 120. For example, the first electrode layer 120 may be deposited by at least one of titanium (Ti), molybdenum (Mo), tungsten (W), or indium-tin, and the second electrode layer 140 may be plated by Al.

As shown in FIG. 4, a space between the second electrode layers 140 in the plurality of structures 115 may be filled with a filler 400. Herein, the filler 400 has an insulating property and may be a material having a lower thermal expansion coefficient than the second electrode layer 140. For example, the filler 400 may include $Al_2O_3$. According to the embodiment, even when a temperature of the capacitor 100 increases, the space between the plurality of structures 115 is not thermally expanded, such that the capacitor 100 having high reliability may be provided. Alternatively, the filler 400 may include $SiO_2$. Accordingly, the filler 400 may serve as a passivation. FIG. 4 illustrates an example in which the filler 400 is additionally disposed in the structure according to the embodiment of FIG. 3, among the embodiments of FIGS. 1 to 3, but it is not limited thereto. The filler 400 may be additionally disposed in the structure according to the embodiments of FIGS. 1 to 2.

Unlike the embodiments of FIGS. 1 to 4 in which the second electrode layer 140 is deposited along the shape of the first dielectric layer 130, referring to FIG. 5, the second electrode layer 140 may be disposed to fill the space between the plurality of structures 115. Accordingly, since the total resistance of the capacitor 100 may be reduced, a capacitor having a fast response rate can be provided. FIG. 5 illustrates an example in which the second electrode layer 140 fills the space between the plurality of structures 115 in the structure according to the embodiment of FIG. 3, among the embodiments of FIGS. 1 to 3, but it is not limited thereto.

Meanwhile, although the description has been mainly provided with respect to an example in which the first electrode layer 120, the first dielectric layer 130, and the second electrode layer 140 are sequentially stacked on the base 110, the present invention is not limited thereto. According to an embodiment of the present invention, a dielectric layer and an electrode layer may be additionally disposed alternately on the second electrode layer 140.

Referring to FIG. 6, the second dielectric layer 180 is disposed on the second electrode layer 140.

In this case, the second dielectric layer 180 may include at least one of $SiO_2$, $Si_3N_3$, $SiN_4$, ZAZ, $HfO_2$, $ZrO_2$, $Hf_xZr_yO_z$, or $Al_2O_3$, where x, y, and z are positive integers. When a material of the second dielectric layer 180 satisfies these conditions, it is easy to deposit the second dielectric layer 140 on the second electrode layer 140 with a uniform thickness.

Next, the third electrode layer 190 is disposed on the second dielectric layer 180.

In this case, the third electrode layer 190 may include at least one of titanium (Ti), molybdenum (Mo), tungsten (W), indium-tin, copper (Cu), or aluminum (Al). For example, the third electrode layer 190 may include at least one of TiN, $TiO_2$, $MoO_x$, $WO_x$, ITO, ITGO, Cu, or and Al, where x is a positive integer.

The material of the third electrode layer 190 may be the same as the materials of the first electrode layer 120 and the second electrode layer 140, but is not limited thereto. That is, the material of the third electrode layer 190 may be different from the materials of the first electrode layer 120 and the second electrode layer 140. For example, the first electrode layer 120 and the second electrode layer 140 include titanium (Ti), molybdenum (Mo), tungsten (W), and indium-tin, and the third electrode layer 190 may include Al. Unlike the embodiment of FIG. 6 in which the third electrode layer 190 is deposited along the shape of the second dielectric layer 180, the third electrode layer 190 may be disposed to fill the space between the plurality of structures 115. According to the embodiment, since the total resistance of the capacitor 100 may be reduced, a capacitor having a fast reaction rate may be provided. FIG. 6 illustrates an example in which the second dielectric layer 180 and the third electrode layer 190 are additionally disposed in the structure according to the embodiment of FIG. 3 among the embodiments of FIGS. 1 to 3, but it is not limited thereto. In the structure according to the embodiments of FIGS. 1 to 2, the second dielectric layer 180 and the third electrode layer 190 may be disposed additionally.

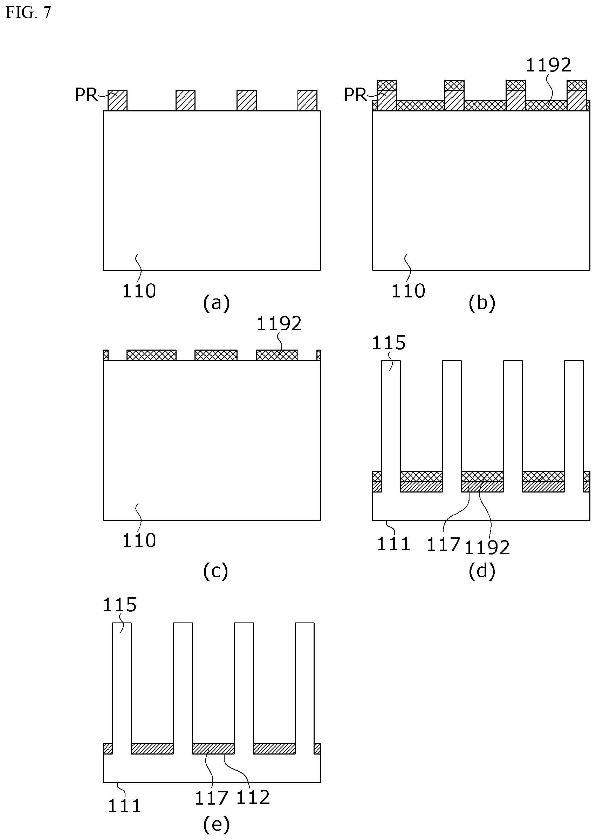

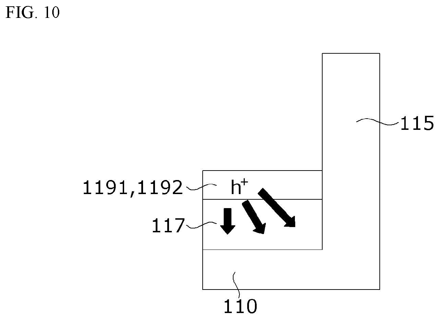

FIGS. 7 to 9 illustrate a method of manufacturing a capacitor according to an embodiment of the present invention, and FIG. 10 is a diagram for describing an etching mechanism in a manufacturing process of a plurality of structures in the capacitor according to an embodiment of the present invention.

Referring to FIG. 7(a), an upper surface of a silicon substrate is patterned into a shape of a structure using photo resists PR. In this case, the silicon substrate may include 90% or more, preferably 99% or more, and more preferably 99.999% or more of silicon.

Referring to FIG. 7(b), a second metal layer 1192 is deposited on the upper surface of the silicon substrate. In this case, the second metal layer 1192 may include at least one of gold (Au) or silver (Ag). In this case, the second metal layer 1192 may be deposited by an evaporator. According to the embodiment, the metal layer is deposited on an upper portion of the photoresists and in exposed regions between photoresists, but is not deposited in regions masked by the photoresists, thereby allowing the photoresists to function as a mask.

Referring to FIG. 7(c), through a lift off process, only the second metal layer 1192 deposited in the exposed regions between the photo resists on the silicon substrate remains.

Referring to FIG. 7(d), the silicon substrate is etched to form a plurality of structures 115. Etching may be performed through a chemical reaction of silicon. For example, when wet etching is performed in the presence of an HF and $H_2O_2$ in a state where the second metal layer 1192 such as gold (Au) or silver (Ag) is deposited on the upper surface of the silicon substrate, etching proceeds through an electrochemical reaction of the second metal layer 1192, silicon, HF, and $H_2O_2$. For example, the etching may proceed through the following chemical reactions.

$$[\text{Reaction Formula 1}] \qquad 3H_2O_2+6H^+ \rightarrow 6H_2O+6h^+$$

$$[\text{Reaction Formula 2}] \qquad 6h^+ +2Si+12HF \rightarrow 2H_2SiF_6+6H^+ +H_2$$

That is, the $6h^+$ generated in the second metal layer 1192 by Reaction Formula 1 may oxidize silicon (Si).

The overall reaction formula may be represented as Reaction Formula 3 below.

$$[\text{Reaction Formula 3}] \qquad 2Si+12HF+3H_2O_2 \rightarrow 2H_2SiF_6+6H_2O+H_2$$

Referring to FIG. 10, holes ($h^+$) according to Reaction Formula 1 may oxidize and etch Si under the second metal layer 1192. Accordingly, a porous silicon layer 117 may be formed under the metal layer 1192.

Referring to FIG. 7(e), the second metal layer 1192 is removed. As described above, when the second metal layer 1192 includes gold (Au) or silver (Ag) having a high silicon diffusion coefficient, the gold (Au) or silver (Ag) diffuses during the process of depositing the first electrode layer, the dielectric layer, and the second electrode layer performed in a high-temperature environment, thereby contaminating a chamber and potentially causing defects in the capacitor. When the second metal layer 1192 is removed as shown in FIG. 7(e), diffusion of gold (Au) or silver (Ag) may be prevented.

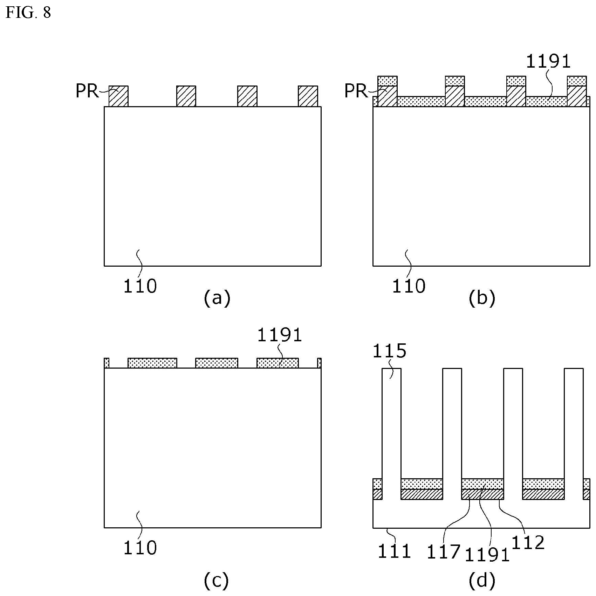

Alternatively, referring to FIG. 8(a), the upper surface of the silicon substrate is patterned into a shape of a structure using photo resists. In this case, the silicon substrate may include 90% or more, preferably 99% or more, and more preferably 99.999% or more of silicon.

Referring to FIG. 8(b), a first metal layer 1191 is deposited on the upper surface of the silicon substrate. Herein, the first metal layer 1191 may include at least one of titanium (Ti) or tungsten (W). In this case, the first metal layer 1191 may be deposited by an evaporator. According to the embodiment, the first metal layer 1191 is deposited only on an upper portion of the photo resists and in exposed regions between the photo resists, but the first metal layer 1191 is not deposited in regions masked by the photo resists, thereby allowing the photoresists to function as a mask.

Referring to FIG. 8(c), through a lift off process, only the first metal layer 1191 deposited in the exposed regions between the photo resists on the silicon substrate remains.

Referring to FIG. 8(d), the silicon substrate is etched to form a plurality of structures 115. Etching may be performed through a chemical reaction of silicon. For example, when wet etching is performed in the presence of an HF and $H_2O_2$ in a state in which the first metal layer 1191 such as titanium (Ti) or tungsten (W) is deposited on the upper surface of the silicon substrate, etching proceeds through an electrochemical reaction of the first metal layer 1191, silicon, HF, and $H_2O_2$. For the chemical reaction for etching, reference may be made to the aforementioned Reaction Formulas 1 to 3.

Accordingly, a porous silicon layer 117 may be formed under the first metal layer 1191. When the first metal layer 1191 includes Ti or W, instead of Au or Ag as shown in FIGS. 8(a) to 8(d), Ti or W has a lower silicon diffusion coefficient than Au or Ag, such that a process for removing the first metal layer 1191, as shown in FIG. 7(e), may be omitted.

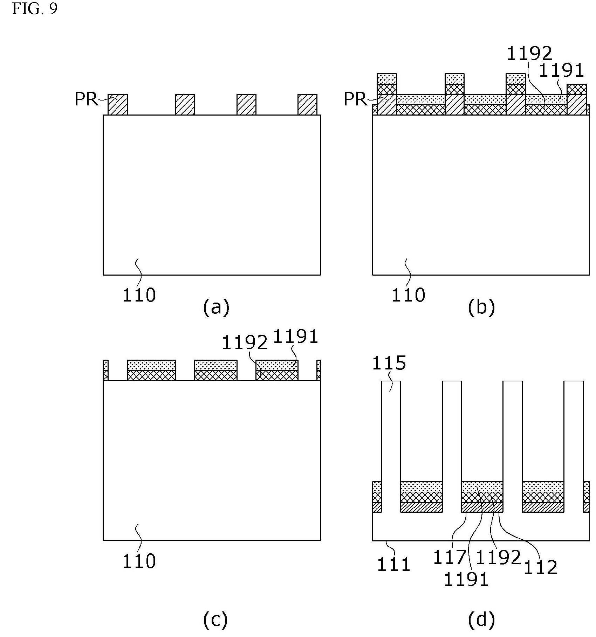

Alternatively, referring to FIG. 9(a), an upper surface of a silicon substrate is patterned into a shape of a structure by using photo resists. Herein, the silicon substrate may include silicon in an amount of 90% or more, preferably 99% or more, and more preferably 99.999% or more.

Referring to FIG. 9(b), a metal bilayer is deposited on the upper surface of the silicon substrate. In this case, the metal bilayer may include a first metal layer 1191 including at least one of titanium (Ti) or tungsten (W) and a second metal layer 1192 including at least one of gold (Au) or silver (Ag). In this case, the first metal layer 1191 and the second metal layer 1192 may be deposited by an evaporator. The first metal layer 1191 may be deposited on the second metal layer 1192. According to the embodiment, the metal layer is deposited only on an upper portion of the photo resists and in exposed regions between the photo resists, and the metal bilayer is not deposited on regions masked by the photo resists, thereby allowing the photo resists to function as a mask.

Referring to FIG. 9(c), through a lift off process, only the metal bilayer deposited on the exposed region between the photo resists on the silicon substrate remains.

Referring to FIG. 9(d), the silicon substrate is etched to form a plurality of structures 115. Etching may be performed through a chemical reaction of silicon. For example, when wet etching is performed in the presence of an HF and $H_2O_2$ while the metal bilayer is deposited on the upper surface of the silicon substrate, the etching proceeds through an electrochemical reaction of the metal layer, silicon, HF, and $H_2O_2$. For the chemical reaction for etching, reference may be made to Reaction Formulas 1 to 3 described above.

Accordingly, a porous silicon layer 117 may be formed under the metal bilayer. As shown in FIGS. 9(a) to 9(d), when the first metal layer 1191, which is disposed on the second metal layer 1192 including Au or Ag and includes Ti or W, is included, a high etching rate may be achieved due to the etching rate of Au or Ag, and a process for removing the metal layer may be omitted due to a low silicon diffusion coefficient of Ti or W.

After forming the plurality of structures 115 on the base 110 as shown in FIGS. 7 to 9, deposition of the first electrode layer 120, the dielectric layer 130, and the second electrode layer 130 may be sequentially performed. The first electrode layer 120 may be deposited using an atomic layer deposition (ALD) process. When the ALD process is used, the material of the first electrode layer 120 may be conformally deposited on the surfaces of the base 110 and the plurality of structures 115 in units of atoms. Accordingly, the first electrode layer 120 may be uniformly deposited on the second surface 112 of the base 110 and side surfaces and top surfaces of the plurality of structures 115.

The first dielectric layer 130 may be deposited using an ALD process. According to the embodiment, the material of the first dielectric layer 130 may be uniformly and conformally deposited on the surface of the first electrode layer 120 in units of atoms.

The second electrode layer 140 may be deposited using an ALD process. According to the embodiment, the material of the second electrode layer 140 may be conformally deposited on the surface of the first dielectric layer 130 in units of atoms. Alternatively, the second electrode layer 140 may be formed on the first dielectric layer 130 by an electrolytic plating process. In this case, the second electrode layer 140 may include Al. When the second electrode layer 140 includes Al, contamination in a chamber may be prevented due to a low silicon diffusion coefficient of Al.

Next, the first electrode pad 150 is connected on the first electrode layer 120, and the second electrode pad 160 is connected on the second electrode layer 140. In order to connect the first electrode pad 150 to the first electrode layer 120, the second electrode layer 140 and the first dielectric layer 130 may be etched. Furthermore, the first electrode pad 150 and the second electrode pad 160 may be deposited by sputtering.

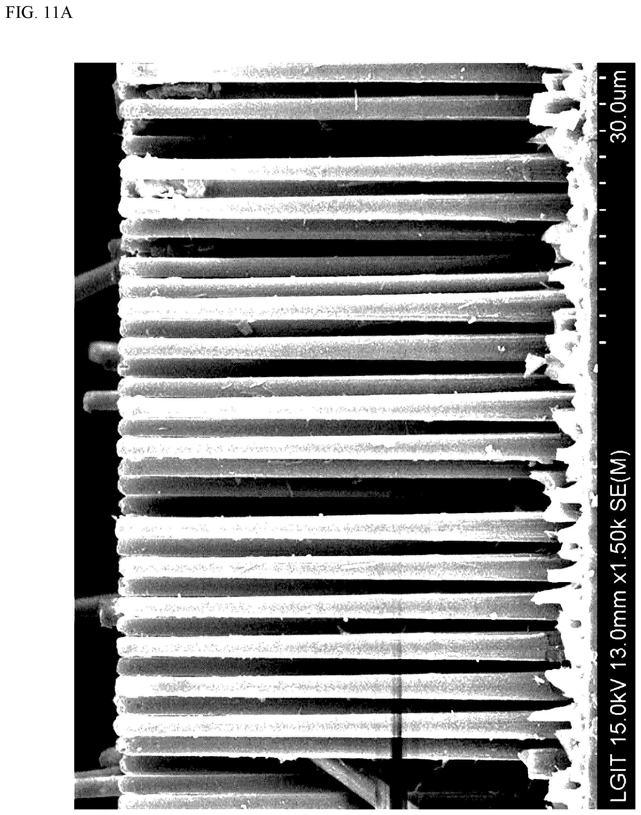

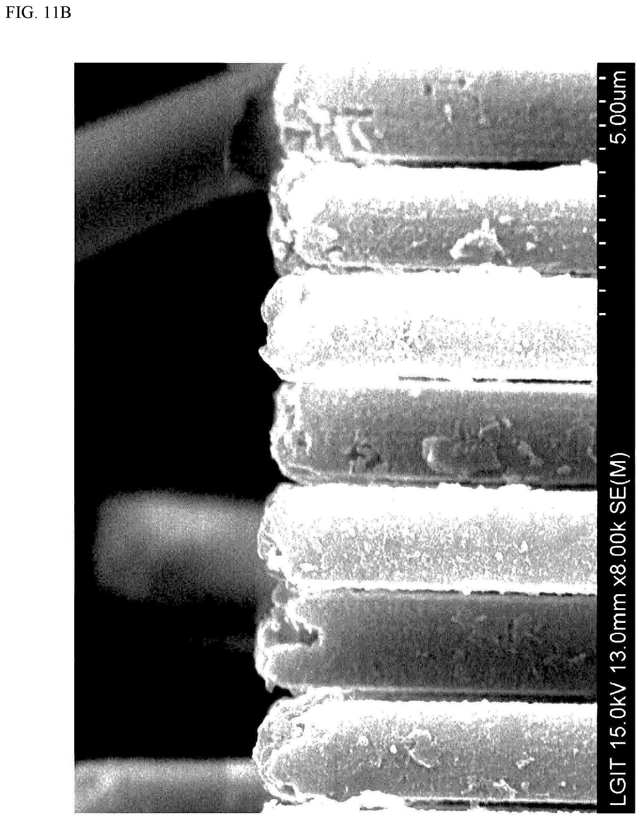

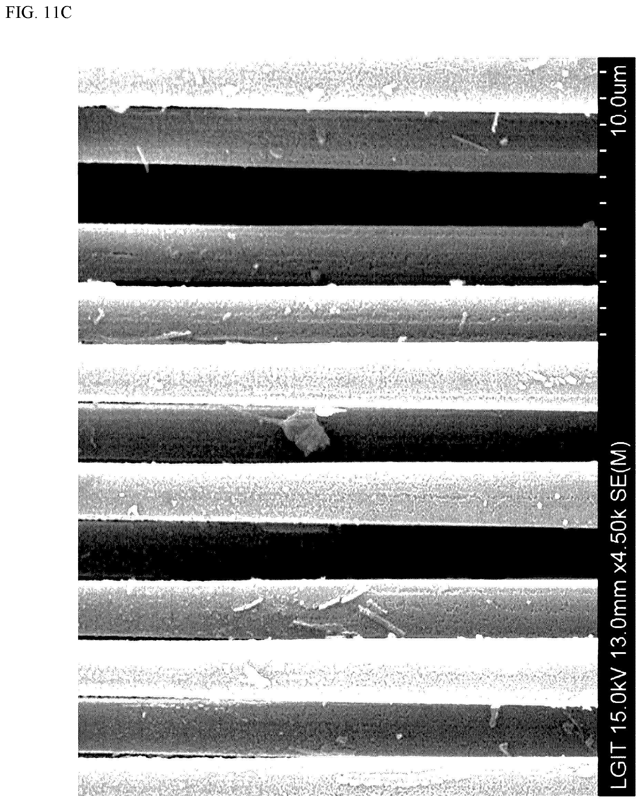

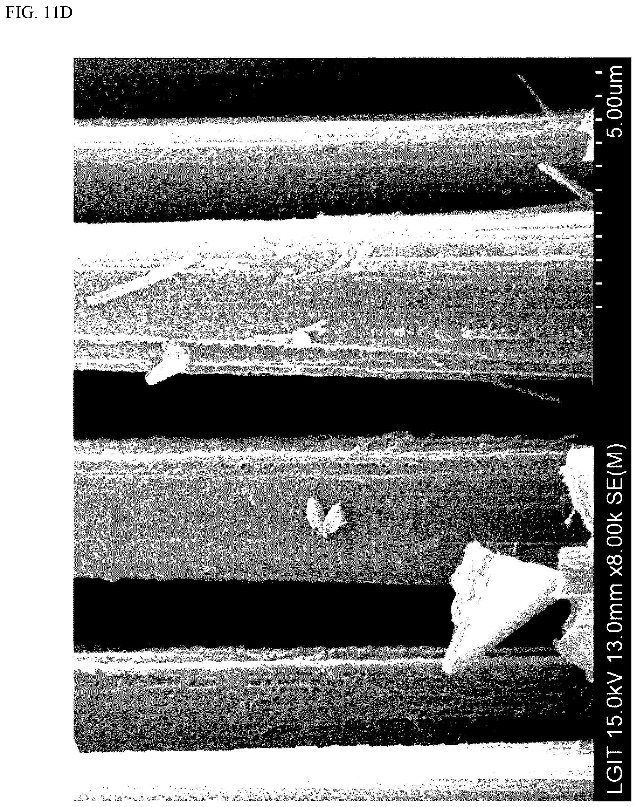

FIG. 11 is SEM images of structures manufactured according to an embodiment of the present invention. FIG. 11(a) is an image of a plurality of structures formed by etching a silicon substrate, FIG. 11(b) is an enlarged image of an upper portion of the structure, FIG. 11(c) is an image of a middle portion of the structure, and FIG. 11(d) is an image of a bottom portion of the structure. Referring to FIGS. 11(a) to 11(d), according to an embodiment of the present invention, a structure having a width of 2.52 $\mu$m, a height of 52 $\mu$m, and an aspect ratio of 20.6 may be obtained.

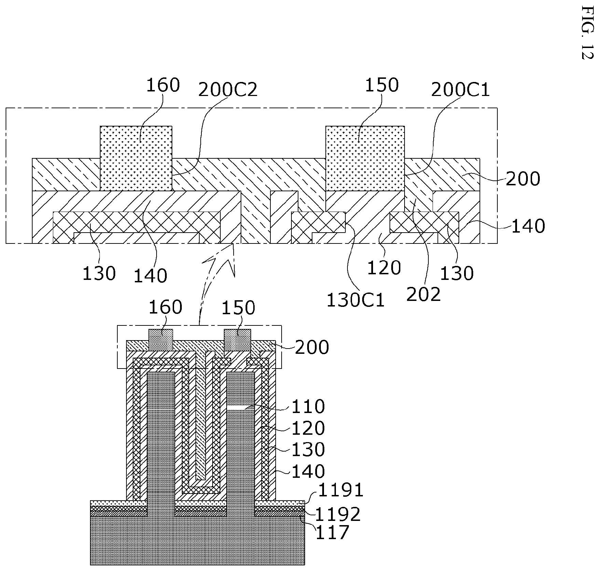

FIGS. 12 to 13 are cross-sectional views of a capacitor according to yet another embodiment of the present invention. Redundant descriptions of the same features already described with reference to FIGS. 1 to 11 will be omitted.

Referring to FIG. 12, a capacitor 100 includes a base 110, a plurality of structures 115, a porous layer 117, a first metal layer 1191, a second metal layer 1192, a first electrode layer 120, a first dielectric layer 130, a second electrode layer 140, a first electrode pad 150 connected to the first electrode layer 120, and a second electrode pad 160 connected to the second electrode layer 140.

To arrange the first electrode pad 150 and the second electrode pad 160, an insulating layer 200 disposed on the second electrode layer 140 is further included according to an embodiment of the present invention. As illustrated, the insulating layer 200 may extend between the second electrode layers 140 on the side surfaces of the plurality of structures 115, thereby functioning as perform a filler.

On the second electrode layer 140 on the upper surfaces of the plurality of structures 115, the insulating layer 200 includes a first opening 200C1 and a second opening 200C2. The first electrode pad 150 may be disposed in the first opening 200C1, and the second electrode pad 160 may be disposed in the second opening 200C2. According to the embodiment, the second electrode pad 160 disposed in the second opening 200C2 may be connected to the second electrode layer 140. To connect the first electrode pad 150 disposed in the first opening 200C1 to the first electrode layer 120, the insulating layer 200 may extend along an edge of the first opening 200C1 to the first dielectric layer 130, and the first dielectric layer 130 may include a first hole 130C1 corresponding to the first opening 200C1. According to the embodiment, the first electrode pad 150 may be connected to the first electrode layer 120. In this case, the first dielectric layer 130 around the first hole 130C1 may protrude toward the center of the first hole 130C1 farther than an extension 202 of the insulating layer 200. According to the embodiment, because the electrode layer may be uniformly filled in the first opening 200C1 and the first hole 130C1, the reliability of the capacitor may be improved.

When the first electrode pad 150 and the second electrode pad 160 are arranged in such a structure, the upper surfaces of the first electrode pad 150 and the second electrode pad 160 may be arranged to have the same height. According to the embodiment, when the capacitor 100 according to an embodiment of the present invention is mounted on a printed circuit board, there is no need to separately adjust the heights of the first electrode pad 150 and the second electrode pad 160, thereby improving an assembly process and enhancing a bonding force between the first electrode pad 150 and the second electrode pad 160 and the printed circuit board.

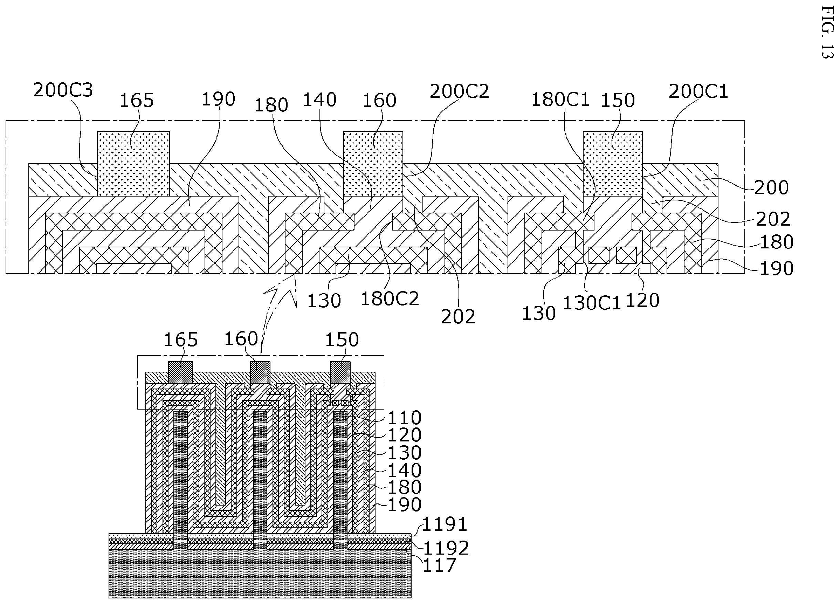

Referring to FIG. 13, the capacitor 100 includes a base 110, a plurality of structures 115, a porous layer 117, a first metal layer 1191, a second metal layer 1192, a first electrode layer 120, a first dielectric layer 130, a second electrode layer 140, a second dielectric layer 180, a third electrode layer 190, a first electrode pad 150 connected to the first electrode layer 120, a second electrode pad 160 connected to the second electrode layer 140, and a third electrode pad 165 connected to the third electrode layer 190.

To arrange the first electrode pad 150, the second electrode pad 160, and the third electrode pad 165, the insulating layer 200 disposed on the third electrode layer 190 is further included according to an embodiment of the present invention. As illustrated, the insulating layer 200 may extend between the third electrode layers 190 on the side surfaces of the plurality of structures 115, thereby functioning as a filler.

On the third electrode layer 190 that is on the upper surfaces of the plurality of structures 115, the insulating layer 200 includes a first opening 200C1, a second opening 200C2, and a third opening 200C3. The first electrode pad 150 may be disposed in the first opening 200C1, the second electrode pad 160 may be disposed in the second opening 200C2, and the third electrode pad 165 may be disposed in the third opening 200C3. According to the embodiment, the third electrode pad 165 disposed in the third opening 200C3 may be connected to the third electrode layer 190.

To connect the first electrode pad 150 disposed in the first opening 200C1 to the first electrode layer 120, the insulating layer 200 may extend along an edge of the first opening 200C1 to the second dielectric layer 180, and the second dielectric layer 180 may include a first hole 180C1 corresponding to the first opening 200C1. Furthermore, the second dielectric layer 180 may extend to the first dielectric layer 130 around the first hole 180C1, and the first dielectric layer 130 may include a second hole 130C1 corresponding to the first hole 180C1. Accordingly, the first electrode pad 150 may be connected to the first electrode layer 120. In this case, the second dielectric layer 180 around the first hole 180C1 may protrude toward the center of the first hole 180C1 farther than the extension 202 of the insulating layer 200. According to the embodiment, because the electrode layer may be uniformly filled in the first opening 200C1 and the first hole 180C1, the reliability of the capacitor may be improved.

In addition, at least one dielectric segment 130S may be additionally disposed in the second hole 130C1 so as to be spaced apart from the second hole 130C1. According to the embodiment, because the electrode layer may be uniformly filled in the first opening 200C1, the first hole 180C1, and the second hole 130C1, the reliability of the capacitor may be improved.

Although not shown, a portion of the upper surface of the electrode layer in the first opening 200C1 may be concave. According to the embodiment, when the first electrode pad 150 is bonded, an excess electrode layer does not protrude toward the side surface of the first electrode pad 150, thereby improving the reliability of the capacitor 100.

To connect the second electrode pad 160 disposed in the second opening 200C2 to the second electrode layer 140, the insulating layer 200 may extend along an edge of the second opening 200C2 to the second dielectric layer 180, and the second dielectric layer 180 may include a third hole 180C2 corresponding to the second opening 200C2. According to the embodiment, the second electrode pad 160 may be connected to the second electrode layer 140. In this case, the second dielectric layer 180 around the third hole 180C2 may protrude toward the center of the third hole 180C2 farther than the extension 202 of the insulating layer 200. According to the embodiment, because the electrode layer may be uniformly filled in the second opening 200C2 and the third hole 180C2, the reliability of the capacitor may be improved.

Although not shown, a portion of the upper surface of the electrode layer in the second opening 200C2 may be concave. According to the embodiment, when the second electrode pad 160 is bonded, an excess electrode layer does not protrude toward the side surface of the second electrode pad 160, thereby improving the reliability of the capacitor 100.

When the first electrode pad 150, the second electrode pad 160, and the third electrode pad 165 are arranged in such a structure, the upper surfaces of the first electrode pad 150, the second electrode pad 160, and the third electrode pad 165 may be arranged to have the same height. According to the embodiment, when the capacitor 100 according to an embodiment of the present invention is mounted on a printed circuit board, there is no need to separately adjust the heights of the first electrode pad 150, the second electrode pad 160, and the third electrode pad 165, thereby improving the assembly process and enhancing the bonding force between the first electrode pad 150, the second electrode pad 160, and the third electrode pad 165 and the printed circuit board.

Although the foregoing description has been provided mainly with reference to exemplary embodiments of the present invention, it will be understood by those skilled in the art that various modifications and changes may be made without departing from the spirit and scope of the present invention as set forth in the appended claims.

**Claims**

1. A capacitor comprising:

   a base including a first surface and a second surface opposite to the first surface, and including a plurality of structures protruding from the second surface in a first direction from the first surface toward the second surface;
   a first electrode layer disposed on the second surface between the plurality of structures and the structure;
   a first dielectric layer disposed on the first electrode layer; and
   a second electrode layer disposed on the first dielectric layer,
   wherein the second surface between the plurality of structures is more porous than the structure.

2. The capacitor of claim 1, further comprising a first metal layer disposed between the second surface between the plurality of structures and the first electrode layer,

   wherein the first metal layer includes at least one of titanium (Ti) or tungsten (W), and
   the first metal layer is in direct contact with the first electrode layer.

3. The capacitor of claim 2, further comprising a second metal layer disposed between the second surface between the plurality of structures and the first metal layer,
   wherein the second metal layer includes at least one of gold (Au) or silver (Ag).

4. The capacitor of claim 1, wherein the second surface between the plurality of structures is in direct contact with the first electrode layer.

5. The capacitor of claim 1, wherein an average width of the plurality of structures in a second direction perpendicular to the first direction in which the plurality of structures protrude is 1.5 $\mu$m to 3.5 $\mu$m, and
   an average height of the plurality of structures based on the second surface of the base is 3.5 $\mu$m or greater and 175 $\mu$m or less.

6. The capacitor of claim 1, wherein a ratio of an average height of the plurality of structures based on the second surface of the base to an average width of the plurality of structures in the second direction perpendicular to the first direction in which the plurality of structures protrude is 1 to 50.

7. The capacitor of claim 1, wherein an angle formed between the second surface of the base and a side surface of the structure is 90 degrees to 100 degrees.

8. The capacitor of claim 1, wherein the first electrode layer includes at least one of titanium (Ti), molybdenum (Mo), tungsten (W), indium-tin, or copper (Cu), and
   the second electrode layer includes aluminum (Al).

9. A capacitor comprising:

a base including a first surface and a second surface opposite to the first surface, and including a structure protruding from the second surface along in a direction from the first surface toward the second surface;

a first metal layer disposed on the second surface and including a first through-hole;

a second metal layer disposed on the first metal layer and including a second through-hole;

a first electrode layer disposed on the second metal layer and the structure;

a first dielectric layer disposed on the first electrode layer; and

a second electrode layer disposed on the first dielectric layer,

wherein the structure penetrates the first through-hole and the second through-hole,

an etching rate of the first metal layer is higher than an etching rate of the second metal layer, and

a silicon diffusion coefficient of the second metal layer is lower than a silicon diffusion coefficient of the first metal layer.

10. The capacitor of claim 9, wherein the first metal layer includes at least one of gold (Au) or silver (Ag), and the second metal layer includes at least one of titanium (Ti) or tungsten (W).

FIG. 1

FIG. 2

FIG. 3

FIG. 4

FIG. 5

FIG. 6

115
120
130
140
180
190

1191
1192
117
112

165

160

150

100

H

110
111

112

112

112

113

D

FIRST DIRECTION

SECOND DIRECTION

FIG. 7

FIG. 8

(a)

(b)

(c)

(d)

FIG. 9

(a)

(b)

1192
1191

(c)

1192 1191

(d)

115

111  117  1192  112
1191

FIG. 10

FIG. 11A

FIG. 11B

FIG. 11C

FIG. 11D

FIG. 12

FIG. 13

## INTERNATIONAL SEARCH REPORT

| International application No. |
|---|
| **PCT/KR2024/012790** |

| A. | CLASSIFICATION OF SUBJECT MATTER |
|---|---|

**H10N 97/00**(2023.01)i; **H01L 21/033**(2006.01)i

According to International Patent Classification (IPC) or to both national classification and IPC

| B. | FIELDS SEARCHED |
|---|---|

Minimum documentation searched (classification system followed by classification symbols)

H10N 97/00(2023.01); H01G 4/228(2006.01); H01G 4/33(2006.01); H01L 21/8242(2006.01); H01L 23/522(2006.01); H01L 27/108(2006.01); H01L 49/02(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 캐패시터(capacitor), 전극층(electrode layer), 유전체(dielectric), 금속층(metal layer), 다공성(porosity)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2019-0033239 A (SAMSUNG ELECTRO-MECHANICS CO., LTD.) 29 March 2019 (2019-03-29)<br>See paragraphs [0030]-[0041]; and figures 1-3 and 8. | 1-10 |
| A | KR 10-2013-0132519 A (TESSERA, INC.) 04 December 2013 (2013-12-04)<br>See paragraphs [0103]-[0116]; and figure 7a. | 1-10 |
| A | KR 10-2021-0007984 A (MURATA MANUFACTURING CO., LTD. et al.) 20 January 2021 (2021-01-20)<br>See paragraphs [0048]-[0079]; and figures 5a-6. | 1-10 |
| A | JP 2020-027821 A (TAIYO YUDEN CO., LTD.) 20 February 2020 (2020-02-20)<br>See paragraphs [0026]-[0047]; and figure 2. | 1-10 |
| A | US 2022-0310513 A1 (KEY FOUNDRY CO., LTD.) 29 September 2022 (2022-09-29)<br>See paragraphs [0038]-[0072]; and figures 1-10. | 1-10 |

☐ Further documents are listed in the continuation of Box C.      ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **02 December 2024** | **02 December 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

| International application No. |
|---|
| **PCT/KR2024/012790** |

| Patent document cited in search report | | | Publication date (day/month/year) | Patent family member(s) | | | Publication date (day/month/year) |
|---|---|---|---|---|---|---|---|
| KR | 10-2019-0033239 | A | 29 March 2019 | CN | 109545778 | A | 29 March 2019 |
| | | | | CN | 109545778 | B | 09 September 2022 |
| | | | | CN | 115360175 | A | 18 November 2022 |
| | | | | JP | 2019-057703 | A | 11 April 2019 |
| | | | | JP | 7259173 | B2 | 18 April 2023 |
| | | | | US | 10811193 | B2 | 20 October 2020 |
| | | | | US | 2019-0088419 | A1 | 21 March 2019 |
| KR | 10-2013-0132519 | A | 04 December 2013 | CN | 103348442 | A | 09 October 2013 |
| | | | | CN | 103348442 | B | 22 March 2017 |
| | | | | CN | 103348443 | A | 09 October 2013 |
| | | | | CN | 103348443 | B | 22 March 2017 |
| | | | | CN | 107045972 | A | 15 August 2017 |
| | | | | CN | 107045972 | B | 05 May 2020 |
| | | | | EP | 2649639 | A1 | 16 October 2013 |
| | | | | EP | 2649639 | B1 | 01 September 2021 |
| | | | | EP | 2649640 | A1 | 16 October 2013 |
| | | | | EP | 2649640 | B1 | 17 August 2022 |
| | | | | EP | 4102585 | A2 | 14 December 2022 |
| | | | | EP | 4102585 | A3 | 22 March 2023 |
| | | | | JP | 2014-505354 | A | 27 February 2014 |
| | | | | JP | 2014-506001 | A | 06 March 2014 |
| | | | | JP | 2016-157946 | A | 01 September 2016 |
| | | | | JP | 5895000 | B2 | 30 March 2016 |
| | | | | JP | 6329977 | B2 | 23 May 2018 |
| | | | | KR | 10-1108947 | B1 | 08 February 2012 |
| | | | | KR | 10-1188918 | B1 | 08 October 2012 |
| | | | | KR | 10-2012-0064610 | A | 19 June 2012 |
| | | | | KR | 10-2012-0064611 | A | 19 June 2012 |
| | | | | TW | 201232580 | A | 01 August 2012 |
| | | | | TW | 201232581 | A | 01 August 2012 |
| | | | | TW | 201430885 | A | 01 August 2014 |
| | | | | TW | I479522 | B | 01 April 2015 |
| | | | | TW | I479523 | B | 01 April 2015 |
| | | | | TW | I546833 | B | 21 August 2016 |
| | | | | US | 10157978 | B2 | 18 December 2018 |
| | | | | US | 11004930 | B2 | 11 May 2021 |
| | | | | US | 2012-0146182 | A1 | 14 June 2012 |
| | | | | US | 2012-0181658 | A1 | 19 July 2012 |
| | | | | US | 2013-0313680 | A1 | 28 November 2013 |
| | | | | US | 2014-0273393 | A1 | 18 September 2014 |
| | | | | US | 2016-0079189 | A1 | 17 March 2016 |
| | | | | US | 2016-0315139 | A1 | 27 October 2016 |
| | | | | US | 2019-0131387 | A1 | 02 May 2019 |
| | | | | US | 2021-0265460 | A1 | 26 August 2021 |
| | | | | US | 8502340 | B2 | 06 August 2013 |
| | | | | US | 8742541 | B2 | 03 June 2014 |
| | | | | US | 9190463 | B2 | 17 November 2015 |
| | | | | US | 9431475 | B2 | 30 August 2016 |
| | | | | US | 9437557 | B2 | 06 September 2016 |
| | | | | WO | 2012-078213 | A1 | 14 June 2012 |

Form PCT/ISA/210 (patent family annex) (July 2022)

## INTERNATIONAL SEARCH REPORT
### Information on patent family members

International application No.

**PCT/KR2024/012790**

| Patent document cited in search report | | | Publication date (day/month/year) | Patent family member(s) | | | Publication date (day/month/year) |
|---|---|---|---|---|---|---|---|
| | | | | WO | 2012-079013 | A1 | 14 June 2012 |
| KR | 10-2021-0007984 | A | 20 January 2021 | CN | 112119512 | A | 22 December 2020 |
| | | | | EP | 3567645 | A1 | 13 November 2019 |
| | | | | TW | 201947648 | A | 16 December 2019 |
| | | | | TW | I810292 | B | 01 August 2023 |
| | | | | US | 11316006 | B2 | 26 April 2022 |
| | | | | US | 2021-0066449 | A1 | 04 March 2021 |
| | | | | WO | 2019-215284 | A1 | 14 November 2019 |
| JP | 2020-027821 | A | 20 February 2020 | JP | 7160594 | B2 | 25 October 2022 |
| | | | | US | 11309134 | B2 | 19 April 2022 |
| | | | | US | 2020-0051749 | A1 | 13 February 2020 |
| US | 2022-0310513 | A1 | 29 September 2022 | KR | 10-2428994 | B1 | 04 August 2022 |

Form PCT/ISA/210 (patent family annex) (July 2022)